# EUROPEAN PATENT APPLICATION

(11) **EP 4 156 245 A1**
(43) Date of publication of application: **29.03.2023**
(21) Application number: 22197175.7
(22) Date of filing: 22.09.2022
(51) Int. Cl.: H01L 21/8252, H01L 27/06, H01L 27/085, H01L 29/423, H01L 29/778

(54) **GROUP III-NITRIDE SEMICONDUCTOR ARRAY WITH HETEROGENEOUS ELECTRODES FOR RADIO FREQUENCY PROCESSING**

(30) Priority: 24.09.2021 US 202117483956
(71) Applicant: INTEL Corporation, Santa Clara, CA 95054 (US)
(72) Inventor: RAMASWAMY, Rahul, Portland, 97229 (US); HAFEZ, Walid M., Portland, 97229 (US); RADOSAVLJEVIC, Marko, Portland, 97229 (US); THEN, Han Wui, Portland, 97229 (US); DASGUPTA, Sansaptak, Portland, 97229 (US)
(74) Representative: 2SPL Patentanwälte PartG mbB

(57) **Abstract**

In one embodiment, an integrated circuit die includes a substrate, a base structure (102, 104, 106a, 106b), and a plurality of semiconductor structures. The substrate includes silicon. The base structure is above the substrate and includes one or more group III-nitride (III-N) materials. The semiconductor structures are in a two-dimensional (2D) layout on the base structure and include a plurality of metal contacts (112a-l), at least some of which have different shapes and comprise different metals.

## Description

### BACKGROUND

Schottky diodes implemented using gallium arsenide (GaA) and aluminum gallium arsenide (AlGaA) can be used for frequency detection in radio frequency (RF) processing circuitry. However, GaA/AlGaA Schottky diodes have low output power (e.g., nanowatts to a few milliwatts) and are typically only capable of detecting narrow bandwidth frequencies (e.g., 2 - 6 gigahertz (GHz)).

### BRIEF DESCRIPTION OF THE DRAWINGS

**FIGS. 1A-B** illustrate a group III-nitride (III-N) semiconductor array with heterogeneous metal contacts in accordance with certain embodiments.
**FIGS. 2A-B** illustrate example embodiments of a III-N transistor.
**FIG. 3** illustrates an example configuration of a III-N semiconductor array with heterogeneous metal contacts.
**FIG. 4** illustrates an example of a current-voltage (I-V) curve for a Schottky diode.
**FIG. 5** illustrates a graph of the absorption coefficients of various metals at different wavelengths.
**FIG. 6** illustrates a flowchart for fabricating a III-N semiconductor array with heterogeneous metal contacts in accordance with certain embodiments.
**FIG. 7** illustrates an example embodiment of a radio frequency transmitter.
**FIG. 8** illustrates an example embodiment of a radio frequency receiver.
**FIG. 9** illustrates a block diagram of an example electrical device that may include one or more embodiments of the disclosure.
**FIG. 10** is a top view of a wafer and dies that may be included in a microelectronic assembly, in accordance with any of the embodiments disclosed herein.
**FIG. 11** is a cross-sectional side view of an integrated circuit device that may be included in a microelectronic assembly, in accordance with any of the embodiments disclosed herein.
**FIG. 12** is a cross-sectional side view of an integrated circuit device assembly that may include a microelectronic assembly, in accordance with any of the embodiments disclosed herein.

### DETAILED DESCRIPTION

Schottky diodes implemented using gallium arsenide (GaA) and aluminum gallium arsenide (AlGaA) can be used for frequency detection in radio frequency (RF) processing circuitry. However, GaA/AlGaA Schottky diodes have low output power (e.g., nanowatts to a few milliwatts) and are typically only capable of detecting narrow bandwidth frequencies (e.g., 2 - 6 gigahertz (GHz)). As a result, they are not suitable for terahertz (THz) frequency detection.

Accordingly, this disclosure presents various embodiments of group III-nitride (III-N) semiconductor devices that are suitable for detecting terahertz frequencies. In particular, III-N semiconductors-such as gallium nitride (GaN) and aluminum gallium nitride (AlGaN)-have several advantages over other semiconductors. For example, GaN has a direct and wide band gap, high breakdown field, high electron mobility, thermal stability (e.g., a high melting point), and the ability to form a high-mobility two-dimensional electron gas (2DEG) when deposited on another III-V/III-N semiconductor. As a result, GaN devices (e.g., diodes and transistors) are particularly beneficial for high-power and high-frequency electronic devices that operate at high temperatures.

This disclosure presents embodiments of a chip array that leverages III-N semiconductors for wideband frequency detection, such as terahertz frequency detection. In some embodiments, for example, an array of semiconductor structures (e.g., Schottky diodes/transistors) with heterogeneous electrodes is implemented on a III-N base structure or stack, which includes various layers of III-N materials (e.g., GaN, AlGaN) and a two-dimensional electron gas (2DEG). For example, multiple Schottky diodes designed with different types of metals, shapes, and dimensions may be implemented on a single chip. In particular, the design of each Schottky diode can be tailored to detect different high frequencies by varying the metal(s), shape, and/or dimensions of the metal diode. In this manner, the varied impedance and dimensions of the diodes due to the design variations enables multiple frequency coupling of different wideband frequencies, which enables the diodes to collectively perform wideband frequency detection.

These embodiments provide numerous advantages. For example, the described embodiments can be used to implement radio frequency (RF) processing circuitry (e.g., RF mixers, RF front ends, RF transceivers) that supports wideband frequencies, including terahertz frequencies. Moreover, the described embodiments are suitable for variety of applications and use cases, including high frequency communication (e.g., 5G cellular/millimeter wave (mmWave)), radar technology, and medical imaging, among other examples. Further, standard semiconductor/silicon processing techniques can be used to fabricate the described embodiments by fabricating multiple Schottky diodes with different designs on a single die.

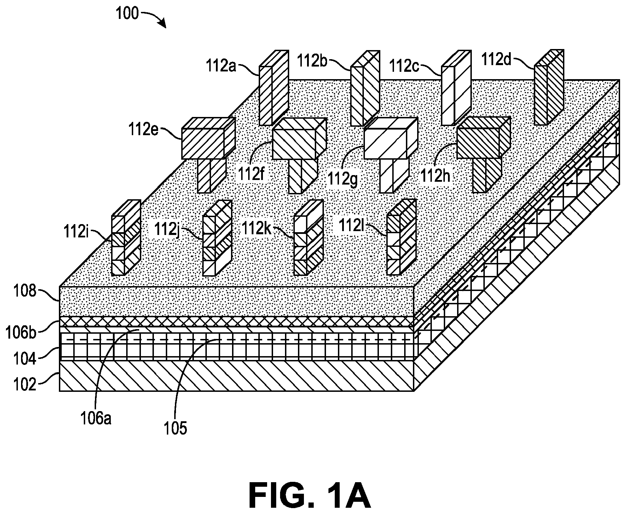

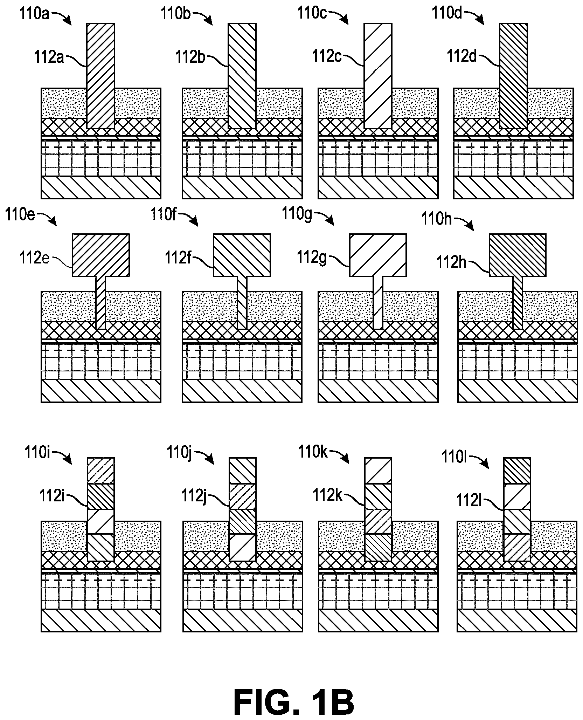

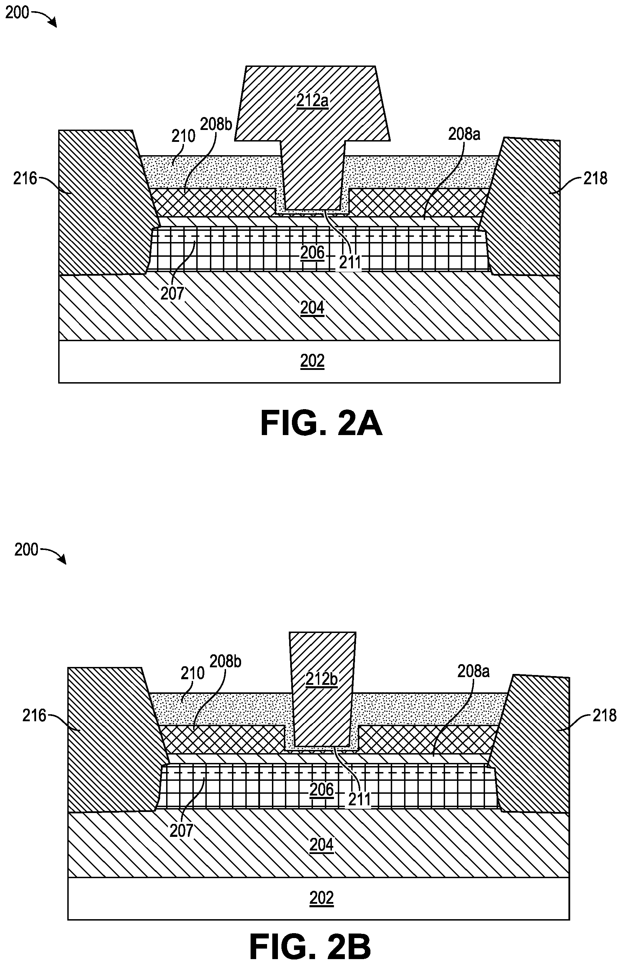

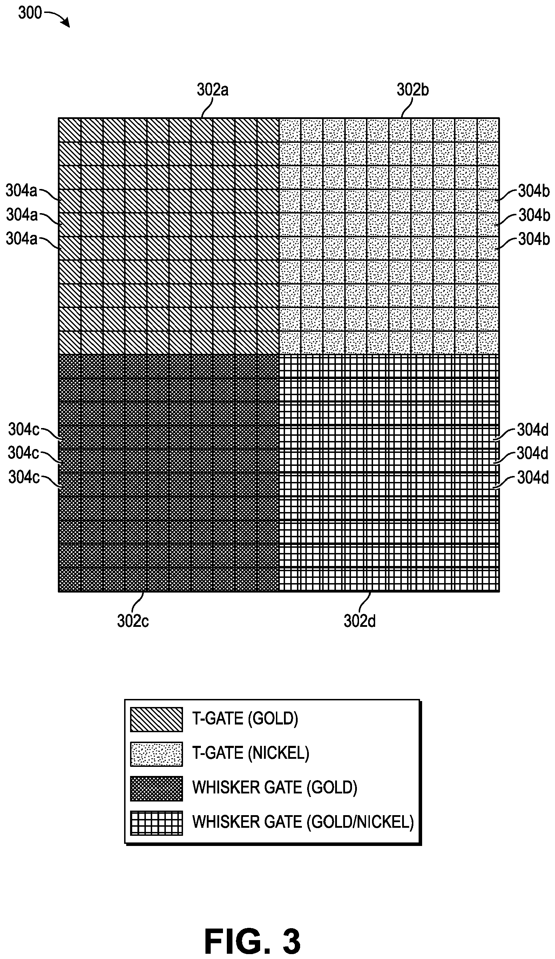

**FIGS. 1A-B** illustrate a group III-nitride (III-N) semiconductor array 100 with heterogeneous metal contacts 112 in accordance with certain embodiments. In particular, FIG. 1A illustrates a three-dimensional (3D) view of the semiconductor array structure 100, while FIG. 1B illustrates a cross-section view the individual semiconductor structures 110a-l within the array 100. In the illustrated example, the design of the semiconductor array 100, including the base layers 102-108 and individual semiconductor structures 110a-l, is simplified for ease of understanding. However, additional details regarding the layout and materials of these components are shown and described in connection with FIGS. 2A-B and FIG. 3.

In the illustrated embodiment, the array 100 includes a base structure, or stack of layers, which may be formed on a silicon substrate (not shown). The base structure includes a buffer 102, a channel 104, polarization layers 106a,b, a two-dimensional electron gas (2DEG) 105, and a dielectric layer 108. Moreover, the buffer 102, channel 104, and polarization layers 106a,b may be formed using one or more III-N materials (e.g., GaN, AlGaN).

Further, multiple semiconductor structures 110a-l with heterogenous metal contacts 112a-l are formed on the base structure in a two-dimensional (2D) layout. In some embodiments, for example, the semiconductor structures 110a-l may be Schottky transistors (e.g., transistors implemented with a Schottky diode) implemented on a single chip, and the metal contacts 112a-l may be the gate electrodes of the transistors.

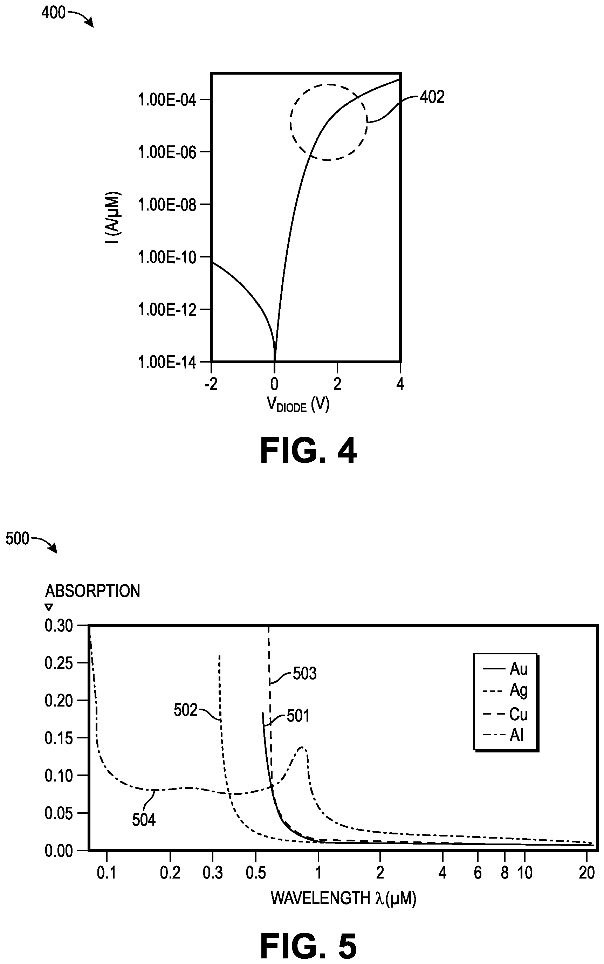

In the illustrated embodiment, the gate electrodes 112a-l are implemented with heterogenous designs to enable broadband width frequency detection. In particular, each gate 112a-l is designed to detect certain frequencies by tailoring the metal material(s) and geometry (e.g., shape/dimensions) used to implement the gate. For example, different types of metal vary in resistance and in their ability to absorb different wavelengths (e.g., as shown and described in connection with FIG. 5). As a result, some metals are more suitable than others for detecting certain frequencies. Thus, the metal(s) and geometry of each gate 112a-l can be adjusted to vary the impedance of the gate and tailor it for a desired frequency.

In particular, each gate 112a-l can be implemented using (i) a particular metal or combination of metals, (ii) and a particular geometry, such as a particular shape with certain dimensions. In the illustrated embodiment, for example, gates 112a-d are implemented as whisker gates-which have a long and narrow vertical shape that resembles a whisker or pillar-and each whisker gate 112a-d is implemented using a different type of metal. Further, gates 112e-h are implemented as T-gates-which have a shape that resembles the letter "T" (e.g., with a wider upper portion and narrower lower portion)-and each T-gate 112e-h is implemented using a different type of metal. Finally, gates 112i-l are implemented as hybrid whisker gates-which are whisker gates implemented using a combination of metals-and each hybrid gate 112i-l has a different arrangement of metals in different regions of the gate.

Different combinations of shapes and metals can provide different advantages. For example, the "T" shape of a T-gate provides better coverage to absorb radiation and couple to a 2DEG system, which makes the T-gate suitable for use as an antenna for radiation coupling. Moreover, each gate can be patterned with a different type of metal to absorb different frequencies. For example, by altering the type of metal used to implement a T-gate (e.g., tungsten, gold, nickel, platinum), the frequencies absorbed by the T-gate antenna can be tuned. In particular, gold has good impedance matching capability and absorbs high frequencies, and thus gold may be used to implement certain gates designed for high frequencies. As another example, multiple different types of metal can be deposited within the same T-gate to further tune the frequencies it absorbs. For example, a hybrid T-gate implemented with multiple different metals-having different absorption coefficients for different wavelengths-can be used to couple various frequencies (e.g., multiple mmWave and sub-mmWave frequencies).

The dimensions of gates, such as the height, width, or depth, can also be tuned. As an example, some T-gates could be implemented with a base or stem that is 90 nanometers (nm) wide, some could have their stems shrunk to 70 nm, and others could have their stems enlarged to 1 micron.

In some embodiments, the chip array 100 can be used for high frequency detection in radio frequency (RF) processing circuitry. In particular, an array 100 of heterogenous Schottky diodes/transistors on an AlGaN/GaN 2DEG stack can be used to implement multiple-input multiple-output (MIMO) on-chip mixers for terahertz frequencies. For example, high frequency detection in the chip array 100 occurs by mixing of two high frequency signals and down conversion to lower gigahertz frequencies. The mixer uses the non-linear behavior of the diodes for detection and down conversion of terahertz frequencies. For example, the Schottky diodes/transistors can be biased to produce non-linear current-voltage (I-V) behavior (e.g., by applying a bias via the source/drain), causing them to behave as mixers (e.g., as shown and described in FIG. 4). This design also enables the RF mixer to be incorporated onto a single chip along with other RF processing components.

**FIGS. 2A-B** illustrate various embodiments of a group III-nitride (III-N) transistor 200, which may be used to implement one or more of the semiconductor structures in the III-N array 100 of FIG. 1. In particular, FIG. 2A illustrates an embodiment of the transistor 200 with a T-gate 212a, and FIG. 2B illustrates an embodiment of the transistor 200 with a whisker or pillar gate 212b.

In the illustrated embodiments, transistor 200 is a high-electron-mobility transistor (HEMT), and more specifically, a Schottky HEMT transistor (e.g., a HEMT transistor with a Schottky diode). Moreover, transistor 200 includes a substrate 202, a buffer layer 204, a transistor channel 206, source and drain regions 216, 218, polarization layers 208a,b, a gate dielectric 210, and a gate electrode 212.

In some embodiments, the substrate 202 may include silicon (e.g., Si(111)). The buffer 204 is formed on or above the substrate 202 and may include one or more layers of III-N materials, such as aluminum nitride (AlN) and/or aluminum gallium nitride (AlGaN).

The transistor channel 206 is formed on or above the buffer layer 204 and may also include one or more layers of III-N materials, such as gallium nitride (GaN). In this manner, a III-N buffer layer 204 (e.g., AlGaN) is between a III-N channel layer 206 (e.g., GaN) and the Si substrate 202 and serves as a buffer separating those layers.

The source region 216 and the drain region 218 are formed on opposite ends of the channel 206 and are coupled together via the channel 206. In some embodiments, the source and drain regions 216, 218 may be formed from one or more III-N materials, such as indium gallium nitride (e.g., N+ InₓGa₁₋ₓN, where x is between 0 and 0.3 and the dopant is Si).

Moreover, source and drain contacts (not shown) may be formed on or above above- and in contact with-the respective source and drain regions 216, 218. The source and drain contacts may include an electrically conductive material, such as a metal.

The polarization stack 208a,b is formed on or above the channel 206 and may include one or more layers 208a,b of III-N materials, such as aluminum nitride (AlN), aluminum indium nitride (AlInN), aluminum gallium nitride (AlGaN), and/or aluminum indium gallium nitride (AlInGaN). The function of the polarization layer(s) 208a,b is to induce the formation of a two-dimensional electron gas (2DEG) 207. For example, the respective III-N materials used in the channel 206 (e.g., GaN) and the polarization layer(s) 208a,b (e.g., AlN, AlInN, AlGaN, AlInGaN) may have different band gaps. In this manner, when the polarization layer(s) 208a,b is deposited on the channel 206, a two-dimensional electron gas (2DEG) 207 forms at or near the interface of the channel 206 and the polarization layer(s) 208a,b.

The gate dielectric layer 210 may include a high-k dielectric material (e.g., a material with a relatively high dielectric constant k (κ)) or any other dielectric material (e.g., any of the dielectric and/or high-k dielectric materials described herein).

The gate electrode 212 may include any suitable metal or other conductive material, including gold (Au), nickel (Ni), titanium (Ti), titanium nitride (TiN), platinum (Pt), copper (Cu), tungsten (W), and/or aluminum (Al), among other examples.

Moreover, the shape of the gate electrode 212 may vary in different embodiments. For example, FIG. 2A illustrates an embodiment of the transistor 200 with a T-gate 212a, which has a shape that resembles the letter "T" (e.g., with a wider upper portion and narrower lower portion). FIG. 2B illustrates an embodiment of the transistor 200 with a whisker or pillar gate 212b, which has a shape that is long and narrow (e.g., with a larger height than width). Further, in other embodiments, other gate shapes may also be used (e.g., split gates).

The top end of the gate electrode 212 may be coupled to an interconnect and/or voltage source (not shown), and the bottom end may extend in the opposite direction into the polarization layer(s) 208a,b. In this manner, since the metal gate electrode 212 extends into the III-N (e.g., AlGaN) polarization layer(s) 208a,b, a Schottky barrier 211 is formed at or near an interface of the gate electrode 212 and the polarization layer(s) 208a,b.

The remaining areas of the transistor structure 200 may be filled with an inter-layer dielectric (ILD) (not shown), which may include any suitable dielectric material, such as silicon dioxide (SiO₂), or any of the other dielectric materials described herein.

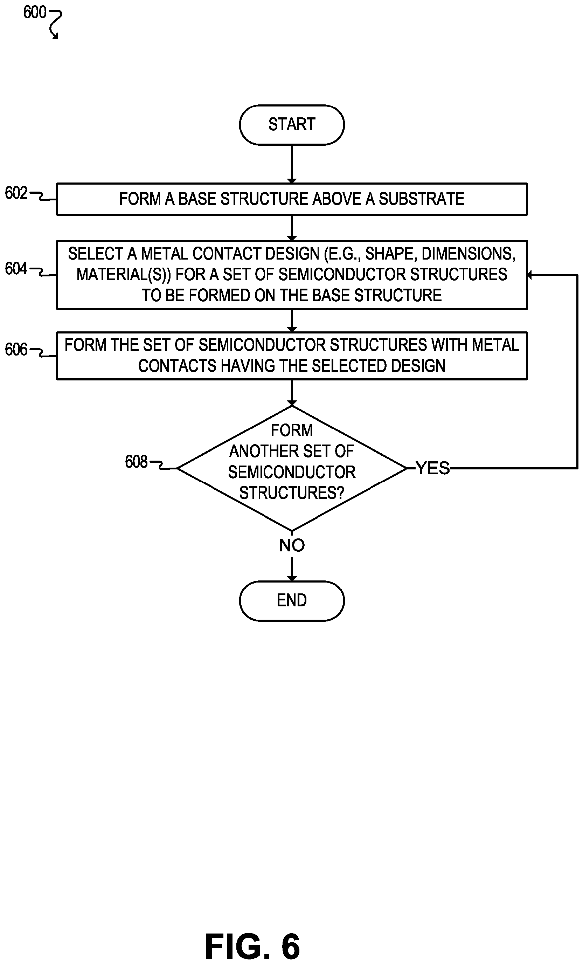

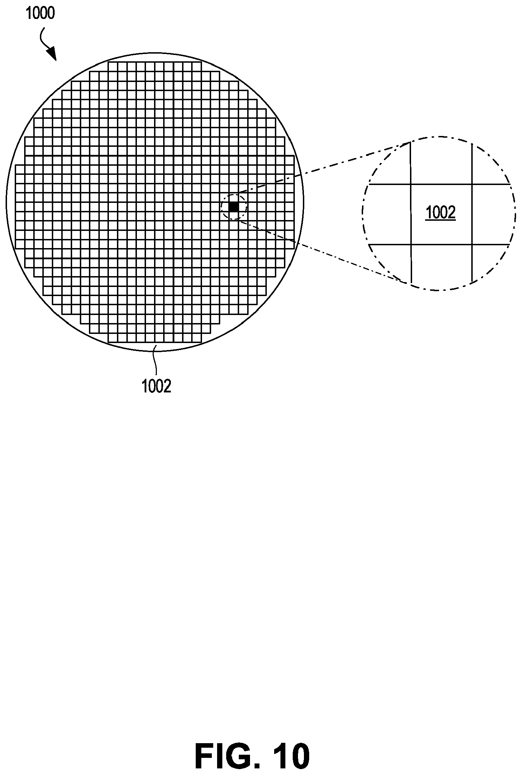

In some embodiments, certain layers of the transistor structure 200 may be omitted, added, or rearranged. Moreover, certain layers may be formed using materials other than those described above, including any of the materials described throughout this disclosure (e.g., in connection with the III-N semiconductor array structure 100 of FIG. 1, the example fabrication process 600 of FIG. 6, and/or the integrated circuit structures of FIGS. 10-12).

**FIG. 3** illustrates an example configuration of a group III-nitride (III-N) semiconductor array 300 with heterogeneous metal contacts. In the illustrated example, array 300 includes a 2x2 arrangement of four sub-arrays 302a-d, each of which includes a 10×10 arrangement of 100 III-N semiconductor structures 304a-d or "islands." In some embodiments, for example, the semiconductor structures may be III-N transistors or diodes, such as the transistor 200 from FIGS. 2A-B. Moreover, in the illustrated embodiment, semiconductor structures 304a-d in the same sub-array 302a-d have metal contacts (e.g., gate electrodes) with the same or similar design (e.g., shape, dimensions, metal(s)), while semiconductor structures 304a-d in different sub-arrays 302a-d have metal contacts with different designs. In this manner, metal contacts that have the same design are arranged contiguously in the same sub-array 302a-d.

As an example, the semiconductor structures 304a in sub-array 302a may include T-gates made of gold, the semiconductor structures 304b in sub-array 302b may include T-gates made of nickel, the semiconductor structures 304c in sub-array 302c may include whisker gates made of gold, and the semiconductor structures 304d in sub-array 302d may include whisker gates made of gold and nickel.

In actual embodiments, the number of sub-arrays 302a-d, and the number of semiconductor structures 304a-d per sub-array, may vary. Moreover, in some embodiments, metal contacts with the same design may not necessarily be arranged contiguously in array 300.

**FIG. 4** illustrates an example of a current-voltage (I-V) curve 400 for a Schottky diode. As shown in the I-V curve 400, when the Schottky diode is biased, it exhibits a non-linear regime 402 suitable for terahertz frequency detection. Thus, by biasing a Schottky diode in a non-linear regime, the diode behaves as a mixer when certain frequencies are applied. In this manner, an array of Schottky diodes designed for various frequencies can be used to implement an RF mixer (e.g., by biasing the diodes to produce the desired non-linear current-voltage (I-V) behavior).

**FIG. 5** illustrates a graph 500 of the absorption coefficients of various metals at different wavelengths. In particular, graph 500 shows the absorption coefficients for gold (Au) 501, silver (Ag) 502, copper (Cu) 503, and aluminum (Al) 504 for wavelengths ranging from 0 - 20 microns (µm). As shown by graph 500, each type of metal absorbs some wavelengths better than others. As a result, some metals are more suitable than others for detecting certain frequencies. Accordingly, the metal(s) used for a particular metal contact or electrode in the III-N semiconductor devices described herein (e.g., the III-N semiconductor array 100 of FIG. 1) may be selected based on the frequency or frequencies that the device is designed to detect (among other factors).

**FIG. 6** illustrates a flowchart 600 for fabricating a group III-nitride (III-N) semiconductor array with heterogeneous metal contacts in accordance with certain embodiments. In some embodiments, for example, flowchart 600 may be used to fabricate the III-N semiconductor array 100 of FIG. 1. It will be appreciated in light of the present disclosure, however, that flowchart 600 is only one example methodology for arriving at the example III-N semiconductor structures shown and described throughout this disclosure. Moreover, the steps of flowchart 600 may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metalorganic chemical vapor deposition (MOCVD), molecular beam epitaxy (MBE) atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

In the illustrated embodiment, flowchart 600 is performed to fabricate an array of III-N semiconductor structures (e.g., transistors, diodes)-with heterogenous metal contacts-in a two-dimensional (2D) layout (e.g., rows and columns) on a common base structure. For example, at least some of the metal contacts of the semiconductor structures may have different shapes, dimensions, and/or materials (e.g., metals).

In some embodiments, for example, the array may include multiple sets, or sub-arrays, of semiconductor structures with various types of metal contacts, where each sub-array contains semiconductor structures with the same type of metal contacts. In this manner, semiconductor structures from the same set or sub-array-which have the same type of metal contacts-are contiguous within the array.

Moreover, in some embodiments, the III-N semiconductor array may be incorporated into an integrated circuit for performing radio frequency (RF) processing, such as an RF mixer circuit, an RF front-end circuit, an RF transceiver circuit, or a system-on-a-chip, among other examples.

The flowchart begins at block 602 by forming a base structure on or above a substrate. In some embodiments, the substrate may be formed from one or more materials that include silicon (e.g., Si(111)). Moreover, the base structure is formed on or above the substrate and includes one or more layers of III-N material(s), such as materials that include aluminum (Al), indium (In), gallium (Ga), and/or nitrogen (N). Examples of III-N materials that may be used in the base structure include aluminum nitride (AlN), gallium nitride (GaN), aluminum gallium nitride (AlGaN), aluminum indium nitride (AlInN), and/or aluminum indium gallium nitride (AlInGaN).

In some embodiments, for example, the base structure includes a stack of layers, such as a buffer, a channel, and a polarization layer.

The buffer is formed on or above the substrate and includes one or more layers of III-N material(s), such as materials that include aluminum (Al), indium (In), gallium (Ga), and/or nitrogen (N). In some embodiments, for example, the buffer may include one or more layers of aluminum nitride (AlN) and/or aluminum gallium nitride (AlGaN).

The channel is formed on or above the buffer and includes one or more layers of III-N material(s), such as materials that include aluminum (Al), indium (In), gallium (Ga), and/or nitrogen (N). In some embodiments, for example, the channel may include one or more layers of gallium nitride (GaN). In this manner, the channel and the substrate are separated by the buffer layer, and thus the buffer layer serves as a buffer between the channel and the substrate.

The polarization layer is formed on or above the channel and includes one or more layers of III-N material(s), such as materials that include aluminum (Al), indium (In), gallium (Ga), and/or nitrogen (N). In some embodiments, for example, the polarization layer may include one or more layers of aluminum nitride (AlN), aluminum indium nitride (AlInN), aluminum gallium nitride (AlGaN), and/or aluminum indium gallium nitride (AlInGaN).

Moreover, the respective III-N materials used in the channel and the polarization layer may have different band gaps. In this manner, when the polarization layer is deposited on the channel, a two-dimensional electron gas (2DEG) forms at or near the interface of the channel and the polarization layer.

The flowchart then proceeds to block 604 to select a design-such as shape, dimensions, and material(s)-for the metal contacts in the first set of semiconductor structures to be formed on the base structure. For example, the semiconductor structures in the same set may be fabricated with metal contacts that have the same or similar design, such as the same shape, dimensions, and materials. Moreover, the semiconductor structures in the same set-with the same type of metal contacts-may be fabricated contiguously in the 2D layout on the base structure.

In some embodiments, the shape of the metal contacts may be a T shape, a whisker or pillar shape, a split shape, or any other suitable shape. Moreover, the metal contacts may include one or more layers of metal or other conductive materials, such as material that include gold (Au), nickel (Ni), titanium (Ti), nitrogen (N), titanium nitride (TiN), platinum (Pt), copper (Cu), tungsten (W), and/or aluminum (Al), among other examples.

In some embodiments, for example, the semiconductor structures may be transistors, and the metal contacts may be gate electrodes on the transistors. In this manner, the transistors in the same set may be fabricated with the same type of gate electrodes (e.g., with the same shape, dimensions, and materials) and may be contiguous in the 2D layout on the base structure.

For example, the gate electrodes may be T-gates, whisker or pillar gates, split gates, or any other type of gates having a suitable shape for the particular use case. Moreover, the gate electrodes may be formed using any of the metals, or combination of metals, referenced above or throughout this disclosure.

In some embodiments, the semiconductor structures may be diodes (e.g., Schottky diodes and/or Schottky transistors), and the metal contacts may be anodes or gate electrodes.

The flowchart then proceeds to block 606 to form the set of semiconductor structures with metal contacts having the selected design. For example, the semiconductor structures are formed on the base structure, and each individual semiconductor structure includes a corresponding metal contact with the selected design (e.g., shape, dimensions, material(s)).

For example, the metal contact may have a T shape, whisker/pillar shape, split shape, or any other suitable shape. Moreover, the metal contact may be formed from a conductive material, such as a material that includes a particular type of metal and/or combination of metals(s), as noted above. For example, in some embodiments, the metal contact may be formed from a particular type of metal material (e.g., gold, nickel, or titanium). Alternatively, the metal contact may be formed from multiple types of metal. For example, the metal contact may include multiple metal layers or regions, each of which includes a different type of metal material (e.g., separate regions that include gold, nickel, and titanium, respectively).

Further, in some embodiments, one end of the metal contact (e.g., the bottom end) may extend into the III-N polarization layer (e.g., AlN, AlInN, AlGaN, AlInGaN) of the base structure, thus forming a Schottky barrier at or near the interface of the metal contact and the polarization layer. Moreover, the other end of the metal contact (e.g., the top end) may extend in the opposite direction, where it may be coupled to an interconnect and/or voltage source.

As noted above, for example, the semiconductor structures may be transistors in some embodiments. Thus, in those embodiments, transistors are formed on the base structure, and each individual transistor includes a source region, a drain region, and a gate electrode with the selected gate design.

The source and drain regions are formed on opposite ends of the channel in the base structure. For example, the source region is formed adjacent to one end of the channel, and the drain region is formed adjacent to another end of the channel. In this manner, the source and drain regions are coupled via the channel. In some embodiments, the source and/or drain regions may be formed from a material that includes indium (In), gallium (Ga), and/or nitrogen (N), such as indium gallium nitride (e.g., N+ InₓGa₁₋ₓN, where x is between 0 and 0.3 and the dopant is Si), among other examples. Moreover, source and drain contacts are formed on or above the respective source and drain regions. In some embodiments, the source and/or drain contacts may be formed from an electrically conductive material, such as a metal.

Moreover, a gate electrode with the selected shape, dimensions, and material(s) is formed on or above the base structure. For example, the gate electrode may be a T-gate, whisker/pillar gate, split gate, or a gate having any other suitable shape. Moreover, the gate is formed with the specified dimensions and materials, as noted above.

Further, one end of the gate electrode (e.g., the bottom end) may extend into the III-N polarization layer (e.g., AlN, AlInN, AlGaN, AlInGaN), thus forming a Schottky barrier at or near the interface of the gate electrode and the polarization layer. Moreover, the other end of the gate electrode (e.g., the top end) may extend in the opposite direction, where it may be coupled to an interconnect and/or voltage source.

The remaining empty areas of the transistor structure may be filled with an inter-layer dielectric (ILD), which may include any suitable dielectric material, such as silicon dioxide (SiO₂), or any of the other dielectric materials described herein.

The flowchart then proceeds to block 608 to determine whether to form another set of semiconductor structures. For example, as noted above, the III-N semiconductor array being fabricated by flowchart 600 may include multiple sets of semiconductor structures (e.g., transistors, diodes) with different types of metal contacts. Thus, depending on the design of the array, the flowchart may repeat blocks 604-608 to select a new metal contact design and then form another set of semiconductor structures on the base structure with metal contacts having the selected design. In some embodiments, for example, another set transistors may be formed on the base structure with gate electrodes whose shape, dimensions, or material(s) are different from those that have previously been formed on the base structure.

The flowchart may repeat blocks 604-608 in this manner until all sets of semiconductor structures in the array have been formed. In some embodiments, any empty areas of the semiconductor structures may be filled with an inter-layer dielectric (ILD), which may include any suitable dielectric material, such as silicon dioxide (SiO₂), or any of the other dielectric materials described herein).

At this point, the flowchart may be complete. In some embodiments, however, the flowchart may restart and/or certain blocks may be repeated. For example, in some embodiments, the flowchart may restart at block 602 to continue fabricating another III-N semiconductor array with the same or similar design.

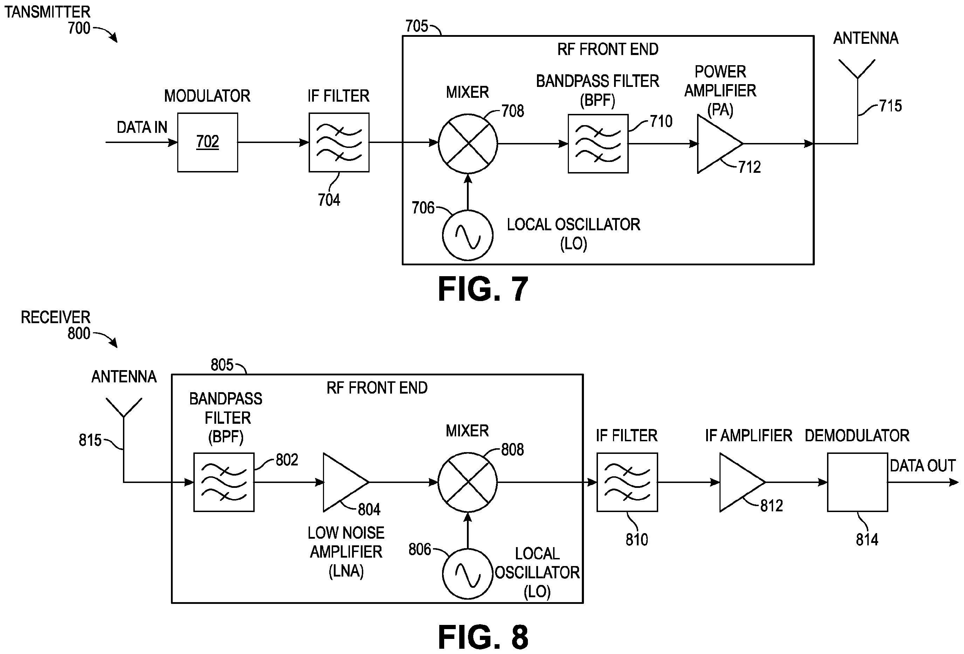

**FIGS. 7-8** illustrate a radio frequency (RF) transmitter 700 and an RF receiver 800 in accordance with certain embodiments. In some embodiments, the transmitter 700 and receiver 800 may be separate components or they may be integrated or combined as a transceiver.

In the illustrated embodiment, the transmitter 700 includes a modulator 702, an intermediate frequency (IF) filter 704, a local oscillator 706, a mixer 708, a bandpass filter 710, a power amplifier 712, and an antenna 715. The local oscillator 706, mixer 708, bandpass filter 710, and power amplifier 712 may be part of the RF front end 705 of the transmitter 700. The components of the transmitter 700 are collectively used to convert an information signal into a carrier signal, which is then transmitted by the antenna 715 as a radio signal (e.g., radio waves).

The radio signal from the transmitter 700 is then received at the receiver 800. In the illustrated embodiment, the receiver 800 includes an antenna 815, a bandpass filter 802, a low noise amplifier 804, a local oscillator 806, a mixer 808, an intermediate frequency (IF) filter 810, an intermediate frequency (IF) amplifier 812, and a demodulator 814. The bandpass filter 802, low noise amplifier 804, local oscillator 806, and mixer 808 may be part of the RF front end 805 of the receiver 800, which is responsible for processing the incoming radio signal at its original radio frequency (RF) before converting the signal to a lower intermediate frequency (IF) for further processing.

For example, when a radio signal is received by the antenna 815, the bandpass filter 802 removes any signal interference at the image frequency and prevents strong out-of-band signals from saturating the input stages. The low noise amplifier 804 is used to amplify weak signals without adding noise. The local oscillator 806 generates a radio frequency signal at an offset from the incoming signal, which is used by the mixer 808. For example, the mixer 808 mixes the incoming signal with the signal from the local oscillator 806 to convert the incoming signal to an intermediate frequency (IF). The remaining processing is then performed on the signal at the intermediate frequency by the other components of the receiver 800, such as the IF filter 810, IF amplifier 812, and demodulator 814.

In some embodiments, one or more components of the transmitter 700 and/or receiver 800, such as the RF front ends 705, 805 and/or mixers 708, 808, may include the III-N semiconductor structures described herein (e.g., the III-N semiconductor array 100 of FIG. 1).

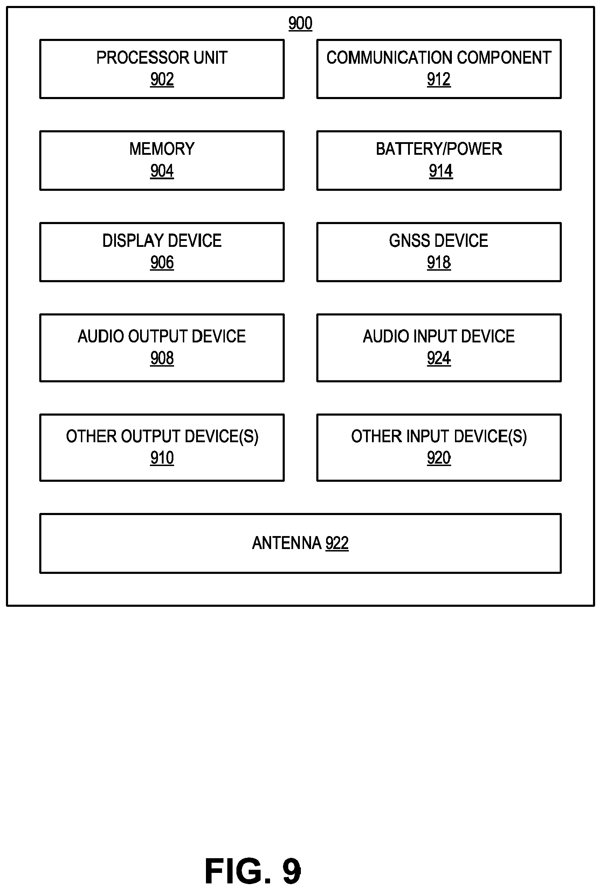

**FIG. 9** illustrates a block diagram of an example electrical device 900 that may include one or more of the embodiments disclosed herein. For example, any suitable ones of the components of the electrical device 900 may include the group III-nitride (III-N) semiconductor structures described herein. In some embodiments for example, the communication components 912 of the electrical device 900 may include radio frequency (RF) processing circuitry, such as an RF transceiver, RF front end, and/or RF mixer. Moreover, the RF processing circuitry may include the III-N semiconductor structures described herein (e.g., the III-N semiconductor array 100 of FIG. 1).

A number of components are illustrated in FIG. 9 as included in the electrical device 900, but any one or more of these components may be omitted or duplicated, as suitable for the application. In some embodiments, some or all of the components included in the electrical device 900 may be attached to one or more motherboards mainboards, or system boards. In some embodiments, one or more of these components are fabricated onto a single system-on-a-chip (SoC) die.

Additionally, in various embodiments, the electrical device 900 may not include one or more of the components illustrated in FIG. 9, but the electrical device 900 may include interface circuitry for coupling to the one or more components. For example, the electrical device 900 may not include a display device 906, but may include display device interface circuitry (e.g., a connector and driver circuitry) to which a display device 906 may be coupled. In another set of examples, the electrical device 900 may not include an audio input device 924 or an audio output device 908, but may include audio input or output device interface circuitry (e.g., connectors and supporting circuitry) to which an audio input device 924 or audio output device 908 may be coupled.

The electrical device 900 may include one or more processor units 902 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 900 may include a memory 904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 904 may include memory that is located on the same integrated circuit die as the processor unit 902. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 900 can comprise one or more processor units 902 that are heterogeneous or asymmetric to another processor unit 902 in the electrical device 900. There can be a variety of differences between the processing units 902 in a system in terms of a spectrum of metrics of merit including architectural, microarchitectural, thermal, power consumption characteristics, and the like. These differences can effectively manifest themselves as asymmetry and heterogeneity among the processor units 902 in the electrical device 900.

In some embodiments, the electrical device 900 may include a communication component 912 (e.g., one or more communication components). For example, the communication component 912 can manage wireless communications for the transfer of data to and from the electrical device 900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 912 may operate in accordance with other wireless protocols in other embodiments. In some embodiments, the communication component 912 may include a radio-frequency (RF) front-end circuit. The electrical device 900 may include an antenna 922 to facilitate wireless communications and/or to receive other wireless communications (such as AM or FM radio transmissions).

In some embodiments, the communication component 912 may manage wired communications, such as electrical, optical, or any other suitable communication protocols (e.g., IEEE 802.3 Ethernet standards). As noted above, the communication component 912 may include multiple communication components. For instance, a first communication component 912 may be dedicated to shorter-range wireless communications such as Wi-Fi or Bluetooth, and a second communication component 912 may be dedicated to longer-range wireless communications such as global positioning system (GPS), EDGE, GPRS, CDMA, WiMAX, LTE, EV-DO, or others. In some embodiments, a first communication component 912 may be dedicated to wireless communications, and a second communication component 912 may be dedicated to wired communications.

The electrical device 900 may include battery/power circuitry 914. The battery/power circuitry 914 may include one or more energy storage devices (e.g., batteries or capacitors) and/or circuitry for coupling components of the electrical device 900 to an energy source separate from the electrical device 900 (e.g., AC line power).

The electrical device 900 may include a display device 906 (or corresponding interface circuitry, as discussed above). The display device 906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 900 may include an audio output device 908 (or corresponding interface circuitry, as discussed above). The audio output device 908 may include any embedded or wired or wirelessly connected external device that generates an audible indicator, such speakers, headsets, or earbuds.

The electrical device 900 may include an audio input device 924 (or corresponding interface circuitry, as discussed above). The audio input device 924 may include any embedded or wired or wirelessly connected device that generates a signal representative of a sound, such as microphones, microphone arrays, or digital instruments (e.g., instruments having a musical instrument digital interface (MIDI) output). The electrical device 900 may include a Global Navigation Satellite System (GNSS) device 918 (or corresponding interface circuitry, as discussed above), such as a Global Positioning System (GPS) device. The GNSS device 918 may be in communication with a satellite-based system and may determine a geolocation of the electrical device 900 based on information received from one or more GNSS satellites, as known in the art.

The electrical device 900 may include other output device(s) 910 (or corresponding interface circuitry, as discussed above). Examples of the other output device(s) 910 may include an audio codec, a video codec, a printer, a wired or wireless transmitter for providing information to other devices, or an additional storage device.

The electrical device 900 may include other input device(s) 920 (or corresponding interface circuitry, as discussed above). Examples of the other input device(s) 920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 900 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 900 may be any other electronic device that processes data. In some embodiments, the electrical device 900 may comprise multiple discrete physical components. Given the range of devices that the electrical device 900 can be manifested as in various embodiments, in some embodiments, the electrical device 900 can be referred to as a computing device or a computing system.

**FIG. 10** is a top view of a wafer 1000 and dies 1002 that may be included in any of the embodiments disclosed herein. The wafer 1000 may be composed of semiconductor material and may include one or more dies 1002 having integrated circuit structures formed on a surface of the wafer 1000. The individual dies 1002 may be a repeating unit of an integrated circuit product that includes any suitable integrated circuit. After the fabrication of the semiconductor product is complete, the wafer 1000 may undergo a singulation process in which the dies 1002 are separated from one another to provide discrete "chips" of the integrated circuit product. The die 1002 may be any of the dies disclosed herein. The die 1002 may include one or more of the III-N semiconductor structures described herein, such as an array of III-N transistors with heterogenous electrodes (e.g., the III-N semiconductor array 100 of FIG. 1), supporting circuitry to route electrical signals to the semiconductor structures/transistors, passive components (e.g., signal traces, resistors, capacitors, or inductors), and/or any other integrated circuit components. In some embodiments, the wafer 1000 or the die 1002 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1002. For example, a memory array formed by multiple memory devices may be formed on a same die 1002 as a processor unit (e.g., the processor unit 902 of FIG. 9) or other logic that is configured to store information in the memory devices or execute instructions stored in the memory array. Various ones of the microelectronic assemblies disclosed herein may be manufactured using a die-to-wafer assembly technique in which some dies are attached to a wafer 1000 that include others of the dies, and the wafer 1000 is subsequently singulated.

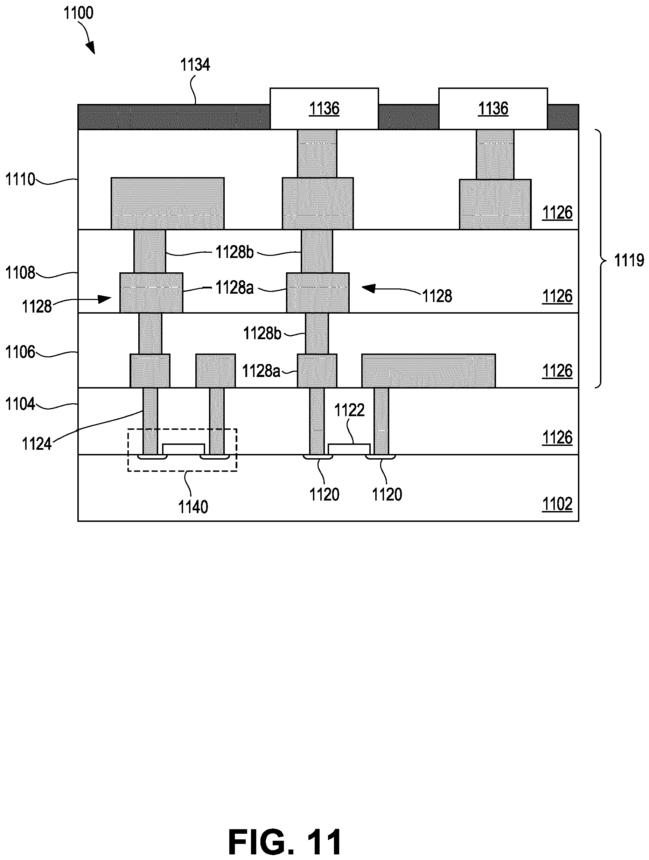

**FIG. 11** is a cross-sectional side view of an integrated circuit device 1100 that may be included in any of the embodiments disclosed herein (e.g., in any of the dies). One or more of the integrated circuit devices 1100 may be included in one or more dies 1002 (FIG. 10). The integrated circuit device 1100 may be formed on a die substrate 1102 (e.g., the wafer 1000 of FIG. 10) and may be included in a die (e.g., the die 1002 of FIG. 10). The die substrate 1102 may be a semiconductor substrate composed of semiconductor material systems including, for example, n-type or p-type materials systems (or a combination of both). The die substrate 1102 may include, for example, a crystalline substrate formed using a bulk silicon or a silicon-on-insulator (SOI) substructure. In some embodiments, the die substrate 1102 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1102. Although a few examples of materials from which the die substrate 1102 may be formed are described here, any material that may serve as a foundation for an integrated circuit device 1100 may be used. The die substrate 1102 may be part of a singulated die (e.g., the dies 1002 of FIG. 10) or a wafer (e.g., the wafer 1000 of FIG. 10).

The integrated circuit device 1100 may include one or more device layers 1104 disposed on the die substrate 1102. The device layer 1104 may include features of one or more transistors 1140 (e.g., metal oxide semiconductor field-effect transistors (MOSFETs)) formed on the die substrate 1102. The transistors 1140 may include, for example, one or more source and/or drain (S/D) regions 1120, a gate 1122 to control current flow between the S/D regions 1120, and one or more S/D contacts 1124 to route electrical signals to/from the S/D regions 1120. The transistors 1140 may include additional features not depicted for the sake of clarity, such as device isolation regions, gate contacts, and the like. The transistors 1140 are not limited to the type and configuration depicted in FIG. 11 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Returning to FIG. 11, a transistor 1140 may include a gate 1122 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1140 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1140 along the source-channel-drain direction, the gate electrode may consist of a U-shaped structure that includes a bottom portion substantially parallel to the surface of the die substrate 1102 and two sidewall portions that are substantially perpendicular to the top surface of the die substrate 1102. In other embodiments, at least one of the metal layers that form the gate electrode may simply be a planar layer that is substantially parallel to the top surface of the die substrate 1102 and does not include sidewall portions substantially perpendicular to the top surface of the die substrate 1102. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1120 may be formed within the die substrate 1102 adjacent to the gate 1122 of individual transistors 1140. The S/D regions 1120 may be formed using an implantation/diffusion process or an etching/deposition process, for example. In the former process, dopants such as boron, aluminum, antimony, phosphorous, or arsenic may be ion-implanted into the die substrate 1102 to form the S/D regions 1120. An annealing process that activates the dopants and causes them to diffuse farther into the die substrate 1102 may follow the ion-implantation process. In the latter process, the die substrate 1102 may first be etched to form recesses at the locations of the S/D regions 1120. An epitaxial deposition process may then be carried out to fill the recesses with material that is used to fabricate the S/D regions 1120. In some implementations, the S/D regions 1120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1120 may be formed using one or more alternate semiconductor materials such as germanium or a group III-V material or alloy. In further embodiments, one or more layers of metal and/or metal alloys may be used to form the S/D regions 1120.

Electrical signals, such as power and/or input/output (I/O) signals, may be routed to and/or from the devices (e.g., transistors 1140) of the device layer 1104 through one or more interconnect layers disposed on the device layer 1104 (illustrated in FIG. 11 as interconnect layers 1106-1110). For example, electrically conductive features of the device layer 1104 (e.g., the gate 1122 and the S/D contacts 1124) may be electrically coupled with the interconnect structures 1128 of the interconnect layers 1106-1110. The one or more interconnect layers 1106-1110 may form a metallization stack (also referred to as an "ILD stack") 1119 of the integrated circuit device 1100.

The interconnect structures 1128 may be arranged within the interconnect layers 1106-1110 to route electrical signals according to a wide variety of designs; in particular, the arrangement is not limited to the particular configuration of interconnect structures 1128 depicted in FIG. 11. Although a particular number of interconnect layers 1106-1110 is depicted in FIG. 11, embodiments of the present disclosure include integrated circuit devices having more or fewer interconnect layers than depicted.

In some embodiments, the interconnect structures 1128 may include lines 1128a and/or vias 1128b filled with an electrically conductive material such as a metal. The lines 1128a may be arranged to route electrical signals in a direction of a plane that is substantially parallel with a surface of the die substrate 1102 upon which the device layer 1104 is formed. For example, the lines 1128a may route electrical signals in a direction in and out of the page and/or in a direction across the page from the perspective of FIG. 11. The vias 1128b may be arranged to route electrical signals in a direction of a plane that is substantially perpendicular to the surface of the die substrate 1102 upon which the device layer 1104 is formed. In some embodiments, the vias 1128b may electrically couple lines 1128a of different interconnect layers 1106-1110 together.

The interconnect layers 1106-1110 may include a dielectric material 1126 disposed between the interconnect structures 1128, as shown in FIG. 11. In some embodiments, dielectric material 1126 disposed between the interconnect structures 1128 in different ones of the interconnect layers 1106-1110 may have different compositions; in other embodiments, the composition of the dielectric material 1126 between different interconnect layers 1106-1110 may be the same. The device layer 1104 may include a dielectric material 1126 disposed between the transistors 1140 and a bottom layer of the metallization stack as well. The dielectric material 1126 included in the device layer 1104 may have a different composition than the dielectric material 1126 included in the interconnect layers 1106-1110; in other embodiments, the composition of the dielectric material 1126 in the device layer 1104 may be the same as a dielectric material 1126 included in any one of the interconnect layers 1106-1110.

A first interconnect layer 1106 (referred to as Metal 1 or "M1") may be formed directly on the device layer 1104. In some embodiments, the first interconnect layer 1106 may include lines 1128a and/or vias 1128b, as shown. The lines 1128a of the first interconnect layer 1106 may be coupled with contacts (e.g., the S/D contacts 1124) of the device layer 1104. The vias 1128b of the first interconnect layer 1106 may be coupled with the lines 1128a of a second interconnect layer 1108.

The second interconnect layer 1108 (referred to as Metal 2 or "M2") may be formed directly on the first interconnect layer 1106. In some embodiments, the second interconnect layer 1108 may include via 1128b to couple the lines 1128 of the second interconnect layer 1108 with the lines 1128a of a third interconnect layer 1110. Although the lines 1128a and the vias 1128b are structurally delineated with a line within individual interconnect layers for the sake of clarity, the lines 1128a and the vias 1128b may be structurally and/or materially contiguous (e.g., simultaneously filled during a dual-damascene process) in some embodiments.

The third interconnect layer 1110 (referred to as Metal 3 or "M3") (and additional interconnect layers, as desired) may be formed in succession on the second interconnect layer 1108 according to similar techniques and configurations described in connection with the second interconnect layer 1108 or the first interconnect layer 1106. In some embodiments, the interconnect layers that are "higher up" in the metallization stack 1119 in the integrated circuit device 1100 (i.e., farther away from the device layer 1104) may be thicker that the interconnect layers that are lower in the metallization stack 1119, with lines 1128a and vias 1128b in the higher interconnect layers being thicker than those in the lower interconnect layers.

The integrated circuit device 1100 may include a solder resist material 1134 (e.g., polyimide or similar material) and one or more conductive contacts 1136 formed on the interconnect layers 1106-1110. In FIG. 11, the conductive contacts 1136 are illustrated as taking the form of bond pads. The conductive contacts 1136 may be electrically coupled with the interconnect structures 1128 and configured to route the electrical signals of the transistor(s) 1140 to external devices. For example, solder bonds may be formed on the one or more conductive contacts 1136 to mechanically and/or electrically couple an integrated circuit die including the integrated circuit device 1100 with another component (e.g., a printed circuit board). The integrated circuit device 1100 may include additional or alternate structures to route the electrical signals from the interconnect layers 1106-1110; for example, the conductive contacts 1136 may include other analogous features (e.g., posts) that route the electrical signals to external components. The conductive contacts 1136 may serve as any of the conductive contacts described throughout this disclosure.

In some embodiments in which the integrated circuit device 1100 is a double-sided die, the integrated circuit device 1100 may include another metallization stack (not shown) on the opposite side of the device layer(s) 1104. This metallization stack may include multiple interconnect layers as discussed above with reference to the interconnect layers 1106-1110, to provide conductive pathways (e.g., including conductive lines and vias) between the device layer(s) 1104 and additional conductive contacts (not shown) on the opposite side of the integrated circuit device 1100 from the conductive contacts 1136. These additional conductive contacts may serve as any of the conductive contacts described throughout this disclosure.

In other embodiments in which the integrated circuit device 1100 is a double-sided die, the integrated circuit device 1100 may include one or more through silicon vias (TSVs) through the die substrate 1102; these TSVs may make contact with the device layer(s) 1104, and may provide conductive pathways between the device layer(s) 1104 and additional conductive contacts (not shown) on the opposite side of the integrated circuit device 1100 from the conductive contacts 1136. These additional conductive contacts may serve as any of the conductive contacts described throughout this disclosure. In some embodiments, TSVs extending through the substrate can be used for routing power and ground signals from conductive contacts on the opposite side of the integrated circuit device 1100 from the conductive contacts 1136 to the transistors 1140 and any other components integrated into the die 1100, and the metallization stack 1119 can be used to route I/O signals from the conductive contacts 1136 to transistors 1140 and any other components integrated into the die 1100.

Multiple integrated circuit devices 1100 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

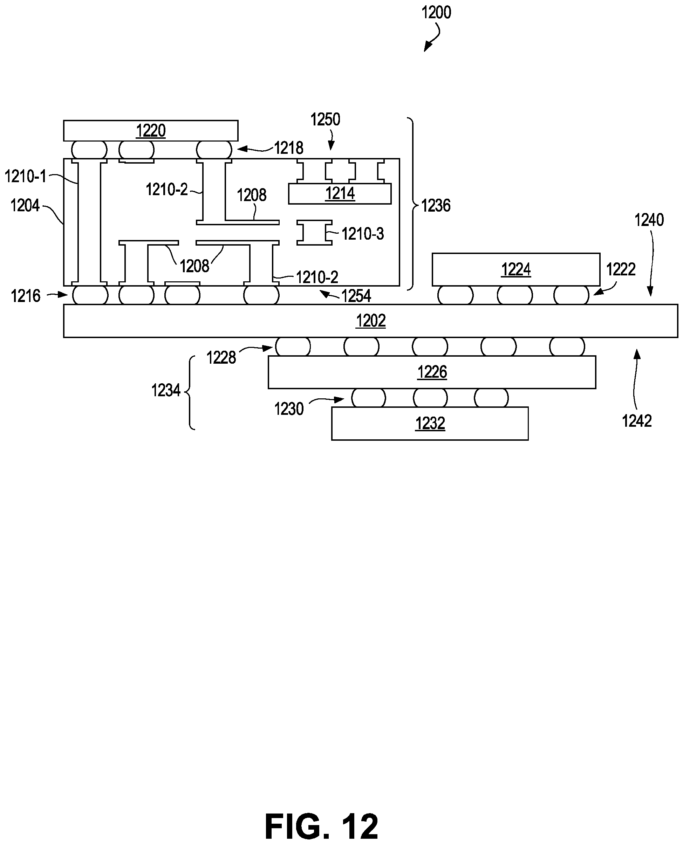

**FIG. 12** is a cross-sectional side view of an integrated circuit device assembly 1200 that may include any of the embodiments disclosed herein. In some embodiments, the integrated circuit device assembly 1200 may be a microelectronic assembly. The integrated circuit device assembly 1200 includes a number of components disposed on a circuit board 1202 (which may be a motherboard, system board, mainboard, etc.). The integrated circuit device assembly 1200 includes components disposed on a first face 1240 of the circuit board 1202 and an opposing second face 1242 of the circuit board 1202; generally, components may be disposed on one or both faces 1240 and 1242. Any of the integrated circuit components discussed below with reference to the integrated circuit device assembly 1200 may take the form of any suitable ones of the embodiments of the microelectronic assemblies 100 disclosed herein.

In some embodiments, the circuit board 1202 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1202. In other embodiments, the circuit board 1202 may be a non-PCB substrate. The integrated circuit device assembly 1200 illustrated in FIG. 12 includes a package-on-interposer structure 1236 coupled to the first face 1240 of the circuit board 1202 by coupling components 1216. The coupling components 1216 may electrically and mechanically couple the package-on-interposer structure 1236 to the circuit board 1202, and may include solder balls (as shown in FIG. 12), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1216 may serve as the coupling components illustrated or described for any of the substrate assembly or substrate assembly components described herein, as appropriate.

The package-on-interposer structure 1236 may include an integrated circuit component 1220 coupled to an interposer 1204 by coupling components 1218. The coupling components 1218 may take any suitable form for the application, such as the forms discussed above with reference to the coupling components 1216. Although a single integrated circuit component 1220 is shown in FIG. 12, multiple integrated circuit components may be coupled to the interposer 1204; indeed, additional interposers may be coupled to the interposer 1204. The interposer 1204 may provide an intervening substrate used to bridge the circuit board 1202 and the integrated circuit component 1220.

The integrated circuit component 1220 may be a packaged or unpacked integrated circuit product that includes one or more integrated circuit dies (e.g., the die 1002 of FIG. 10, the integrated circuit device 1100 of FIG. 11) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1220, a single monolithic integrated circuit die comprises solder bumps attached to contacts on the die. The solder bumps allow the die to be directly attached to the interposer 1204. The integrated circuit component 1220 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1220 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1220 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1220 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1204 may spread connections to a wider pitch or reroute a connection to a different connection. For example, the interposer 1204 may couple the integrated circuit component 1220 to a set of ball grid array (BGA) conductive contacts of the coupling components 1216 for coupling to the circuit board 1202. In the embodiment illustrated in FIG. 12, the integrated circuit component 1220 and the circuit board 1202 are attached to opposing sides of the interposer 1204; in other embodiments, the integrated circuit component 1220 and the circuit board 1202 may be attached to a same side of the interposer 1204. In some embodiments, three or more components may be interconnected by way of the interposer 1204.

In some embodiments, the interposer 1204 may be formed as a PCB, including multiple metal layers separated from one another by layers of dielectric material and interconnected by electrically conductive vias. In some embodiments, the interposer 1204 may be formed of an epoxy resin, a fiberglass-reinforced epoxy resin, an epoxy resin with inorganic fillers, a ceramic material, or a polymer material such as polyimide. In some embodiments, the interposer 1204 may be formed of alternate rigid or flexible materials that may include the same materials described above for use in a semiconductor substrate, such as silicon, germanium, and other group III-V and group IV materials. The interposer 1204 may include metal interconnects 1208 and vias 1210, including but not limited to through hole vias 1210-1 (that extend from a first face 1250 of the interposer 1204 to a second face 1254 of the interposer 1204), blind vias 1210-2 (that extend from the first or second faces 1250 or 1254 of the interposer 1204 to an internal metal layer), and buried vias 1210-3 (that connect internal metal layers).

In some embodiments, the interposer 1204 can comprise a silicon interposer. Through silicon vias (TSV) extending through the silicon interposer can connect connections on a first face of a silicon interposer to an opposing second face of the silicon interposer. In some embodiments, an interposer 1204 comprising a silicon interposer can further comprise one or more routing layers to route connections on a first face of the interposer 1204 to an opposing second face of the interposer 1204.

The interposer 1204 may further include embedded devices 1214, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1204. The package-on-interposer structure 1236 may take the form of any of the package-on-interposer structures known in the art. In embodiments where the interposer is a non-printed circuit board

The integrated circuit device assembly 1200 may include an integrated circuit component 1224 coupled to the first face 1240 of the circuit board 1202 by coupling components 1222. The coupling components 1222 may take the form of any of the embodiments discussed above with reference to the coupling components 1216, and the integrated circuit component 1224 may take the form of any of the embodiments discussed above with reference to the integrated circuit component 1220.

The integrated circuit device assembly 1200 illustrated in FIG. 12 includes a package-on-package structure 1234 coupled to the second face 1242 of the circuit board 1202 by coupling components 1228. The package-on-package structure 1234 may include an integrated circuit component 1226 and an integrated circuit component 1232 coupled together by coupling components 1230 such that the integrated circuit component 1226 is disposed between the circuit board 1202 and the integrated circuit component 1232. The coupling components 1228 and 1230 may take the form of any of the embodiments of the coupling components 1216 discussed above, and the integrated circuit components 1226 and 1232 may take the form of any of the embodiments of the integrated circuit component 1220 discussed above. The package-on-package structure 1234 may be configured in accordance with any of the package-on-package structures known in the art.

### Example Embodiments

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes an integrated circuit die, comprising: a substrate, wherein the substrate comprises silicon; a base structure above the substrate, wherein the base structure comprises one or more group III-nitride (III-N) materials; and a plurality of semiconductor structures in a two-dimensional (2D) layout on the base structure, wherein the plurality of semiconductor structures comprises a plurality of metal contacts, wherein at least some of the plurality of metal contacts have different shapes and comprise different metals.

Example 2 includes the integrated circuit die of Example 1, wherein the plurality of metal contacts comprises: a first set of metal contacts having a first shape and comprising a first metal; a second set of metal contacts having the first shape and comprising a second metal, wherein the second metal is different from the first metal; a third set of metal contacts having a second shape and comprising the first metal, wherein the second shape is different from the first shape; and a fourth set of metal contacts having the second shape and comprising the second metal.

Example 3 includes the integrated circuit die of Example 2, wherein: the first shape is a T shape; and the second shape is a whisker shape.

Example 4 includes the integrated circuit die of any of Examples 2-3, wherein: the first metal comprises gold, nickel, titanium, platinum, copper, or tungsten; and the second metal comprises gold, nickel, titanium, platinum, copper, or tungsten.

Example 5 includes the integrated circuit die of any of Examples 2-4, wherein the plurality of metal contacts further comprises: a fifth set of metal contacts having the first shape or the second shape, wherein individual metal contacts in the fifth set comprise a plurality of metals, wherein the plurality of metals comprises the first metal and the second metal.

Example 6 includes the integrated circuit die of Example 5, wherein individual metal contacts in the fifth set further comprise a plurality of metal regions, wherein individual metal regions comprise a corresponding metal from the plurality of metals.

Example 7 includes the integrated circuit die of any of Examples 2-6, wherein each of the first set of metal contacts, the second set of metal contacts, the third set of metal contacts, and the fourth set of metal contacts is contiguous within the 2D layout on the base structure.

Example 8 includes the integrated circuit die of any of Examples 1-7, wherein the base structure further comprises: a buffer layer above the substrate, wherein the buffer layer comprises a first III-N material; a channel layer above the buffer layer, wherein the channel layer comprises a second III-N material; a polarization layer above the channel layer, wherein the polarization layer comprises a third III-N material; and a two-dimensional electron gas at an interface of the channel layer and the polarization layer.

Example 9 includes the integrated circuit die of Example 8, wherein individual semiconductor structures of the plurality of semiconductor structures comprise: a corresponding metal contact from the plurality of metal contacts, wherein the corresponding metal contact extends into the polarization layer; and a Schottky barrier at an interface of the corresponding metal contact and the polarization layer.

Example 10 includes the integrated circuit die of any of Examples 8-9, wherein: the first III-N material comprises: nitrogen; and aluminum, gallium, or indium; the second III-N material comprises: nitrogen; and aluminum, gallium, or indium; the third III-N material comprises: nitrogen; and aluminum, gallium, or indium.

Example 11 includes the integrated circuit die of any of Examples 1-10, wherein: the plurality of semiconductor structures is a plurality of transistors; and the plurality of metal contacts is a plurality of gate electrodes.

Example 12 includes the integrated circuit die of Example 11, wherein individual transistors of the plurality of transistors comprise: a source region; a drain region; and a corresponding gate electrode from the plurality of gate electrodes.

Example 13 includes an integrated circuit, comprising: radio frequency (RF) mixer circuitry, wherein the RF mixer circuitry comprises: a substrate, wherein the substrate comprises silicon; and a base structure above the substrate, wherein the base structure comprises one or more group III-nitride (III-N) materials; and a plurality of semiconductor structures in a two-dimensional (2D) layout on the base structure, wherein the plurality of semiconductor structures comprises a plurality of metal contacts, wherein at least some of the plurality of metal contacts have different shapes and comprise different metals.

Example 14 includes the integrated circuit of Example 13, wherein the integrated circuit is: an RF mixer circuit; an RF front-end circuit; an RF transceiver circuit; or a system-on-a-chip.

Example 15 includes the integrated circuit of any of Examples 13-14, wherein the plurality of metal contacts comprises: a first set of metal contacts having a first shape and comprising a first metal; a second set of metal contacts having the first shape and comprising a second metal, wherein the second metal is different from the first metal; a third set of metal contacts having a second shape and comprising the first metal, wherein the second shape is different from the first shape; and a fourth set of metal contacts having the second shape and comprising the second metal.

Example 16 includes the integrated circuit of Example 15, wherein the plurality of metal contacts further comprises: a fifth set of metal contacts having the first shape or the second shape, wherein individual metal contacts in the fifth set comprise a plurality of metals, wherein the plurality of metals comprises the first metal and the second metal.

Example 17 includes the integrated circuit of any of Examples 15-16, wherein: the first shape is a T shape; the second shape is a whisker shape; the first metal comprises gold, nickel, titanium, platinum, copper, or tungsten; and the second metal comprises gold, nickel, titanium, platinum, copper, or tungsten.

Example 18 includes the integrated circuit of any of Examples 13-17, wherein: the base structure further comprises: a buffer layer above the substrate, wherein the buffer layer comprises a first III-N material; a channel layer above the buffer layer, wherein the channel layer comprises a second III-N material; a polarization layer above the channel layer, wherein the polarization layer comprises a third III-N material; and a two-dimensional electron gas at an interface of the channel layer and the polarization layer; the plurality of semiconductor structures is a plurality of transistors; the plurality of metal contacts is a plurality of gate electrodes; and individual transistors of the plurality of transistors comprise: a source region; a drain region; and a corresponding gate electrode from the plurality of gate electrodes, wherein the corresponding gate electrode extends into the polarization layer.

Example 19 includes a method of forming an integrated circuit structure, comprising: forming a base structure above a substrate, wherein the substrate comprises silicon, and wherein the base structure comprises one or more group III-nitride (III-N) materials; and forming a plurality of semiconductor structures in a two-dimensional (2D) layout on the base structure, wherein the plurality of semiconductor structures comprises a plurality of metal contacts, wherein at least some of the plurality of metal contacts have different shapes and comprise different metals.

Example 20 includes the method of Example 19, wherein forming the plurality of semiconductor structures in the 2D layout on the base structure comprises forming the plurality of metal contacts, wherein forming the plurality of metal contacts comprises: forming a first set of metal contacts having a first shape and comprising a first metal; forming a second set of metal contacts having the first shape and comprising a second metal, wherein the second metal is different from the first metal; forming a third set of metal contacts having a second shape and comprising the first metal, wherein the second shape is different from the first shape; forming a fourth set of metal contacts having the second shape and comprising the second metal; and forming a fifth set of metal contacts having the first shape or the second shape, wherein individual metal contacts in the fifth set comprise a plurality of metals, wherein the plurality of metals comprises the first metal and the second metal.

Example 21 includes the method of Example 20, wherein: the first shape is a T shape; the second shape is a whisker shape; the first metal comprises gold, nickel, titanium, platinum, copper, or tungsten; and the second metal comprises gold, nickel, titanium, platinum, copper, or tungsten.

Example 22 includes the method of any of Examples 19-21, wherein forming the base structure above the substrate comprises: forming a buffer layer above the substrate, wherein the buffer layer comprises a first III-N material; forming a channel layer above the buffer layer, wherein the channel layer comprises a second III-N material; and forming a polarization layer above the channel layer, wherein the polarization layer comprises a third III-N material.

Example 23 includes the method of Example 22, wherein: the plurality of semiconductor structures is a plurality of transistors; the plurality of metal contacts is a plurality of gate electrodes; and forming the plurality of semiconductor structures in the 2D layout on the base structure comprises forming individual transistors of the plurality of transistors, wherein forming individual transistors comprises: forming a source region; forming a drain region; and forming a corresponding gate electrode of the plurality of gate electrodes, wherein the corresponding gate electrode extends into the polarization layer.

Example 24 includes a computing system, comprising: a processor; a memory; and a radio frequency (RF) front end, wherein the RF front end comprises a radio frequency (RF) mixer, wherein the RF mixer comprises: a substrate, wherein the substrate comprises silicon; and a base structure above the substrate, wherein the base structure comprises one or more group III-nitride (III-N) materials; and a plurality of semiconductor structures in a two-dimensional (2D) layout on the base structure, wherein the plurality of semiconductor structures comprises a plurality of metal contacts, wherein at least some of the plurality of metal contacts have different shapes and comprise different metals.

Example 25 includes the computing system of Example 24, further comprising: a radio frequency (RF) transceiver, wherein the RF transceiver comprises the RF front end; and an antenna coupled to the RF transceiver.

In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure. However, the order of description should not be construed to imply that these operations are necessarily order dependent. In particular, these operations may not be performed in the order of presentation.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

As used herein, the term "circuitry" may refer to, be part of, or include an Application Specific Integrated Circuit (ASIC), an electronic circuit, a processor (shared, dedicated, or group), and/or memory (shared, dedicated, or group) that execute one or more software or firmware programs, a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

## Claims

1. An integrated circuit device, comprising:
a substrate, wherein the substrate comprises silicon;
a base structure above the substrate, wherein the base structure comprises one or more group III-nitride (III-N) materials; and
a plurality of semiconductor structures in a two-dimensional (2D) layout on the base structure, wherein the plurality of semiconductor structures comprises a plurality of metal contacts, wherein at least some of the plurality of metal contacts have different shapes and comprise different metals.

2. The integrated circuit device of Claim 1, wherein the plurality of metal contacts comprises:
a first set of metal contacts having a first shape and comprising a first metal;
a second set of metal contacts having the first shape and comprising a second metal, wherein the second metal is different from the first metal;
a third set of metal contacts having a second shape and comprising the first metal, wherein the second shape is different from the first shape; and
a fourth set of metal contacts having the second shape and comprising the second metal.

3. The integrated circuit device of Claim 2, wherein:
the first shape is a T shape; and
the second shape is a whisker shape.

4. The integrated circuit device of any of Claims 2-3, wherein:
the first metal comprises gold, nickel, titanium, platinum, copper, or tungsten; and
the second metal comprises gold, nickel, titanium, platinum, copper, or tungsten.

5. The integrated circuit device of any of Claims 2-4, wherein the plurality of metal contacts further comprises:
a fifth set of metal contacts having the first shape or the second shape, wherein individual metal contacts in the fifth set comprise a plurality of metals, wherein the plurality of metals comprises the first metal and the second metal.

6. The integrated circuit device of Claim 5, wherein individual metal contacts in the fifth set further comprise a plurality of metal regions, wherein individual metal regions comprise a corresponding metal from the plurality of metals.

7. The integrated circuit device of any of Claims 2-6, wherein each of the first set of metal contacts, the second set of metal contacts, the third set of metal contacts, and the fourth set of metal contacts is contiguous within the 2D layout on the base structure.

8. The integrated circuit device of any of Claims 1-7, wherein the base structure further comprises:
a buffer layer above the substrate, wherein the buffer layer comprises a first III-N material;
a channel layer above the buffer layer, wherein the channel layer comprises a second III-N material;
a polarization layer above the channel layer, wherein the polarization layer comprises a third III-N material; and
a two-dimensional electron gas at an interface of the channel layer and the polarization layer.

9. The integrated circuit device of Claim 8, wherein individual semiconductor structures of the plurality of semiconductor structures comprise:
a corresponding metal contact from the plurality of metal contacts, wherein the corresponding metal contact extends into the polarization layer; and
a Schottky barrier at an interface of the corresponding metal contact and the polarization layer.

10. The integrated circuit device of any of Claims 8-9, wherein:
the first III-N material comprises:
nitrogen; and
aluminum, gallium, or indium;
the second III-N material comprises:
nitrogen; and
aluminum, gallium, or indium;
the third III-N material comprises:
nitrogen; and
aluminum, gallium, or indium.

11. The integrated circuit device of any of Claims 1-10, wherein:
the plurality of semiconductor structures is a plurality of transistors;
the plurality of metal contacts is a plurality of gate electrodes; and
individual transistors of the plurality of transistors comprise:
a source region;
a drain region; and
a corresponding gate electrode from the plurality of gate electrodes.

12. The integrated circuit device of any of Claims 1-11, wherein the integrated circuit device is:
a radio frequency (RF) mixer;
an RF front end;
an RF transceiver; or
a system-on-a-chip.

13. The integrated circuit device of any of Claims 1-11, further comprising:
a processor;
a memory; and
a radio frequency (RF) front end, wherein the RF front end comprises an RF mixer, wherein the RF mixer comprises the substrate, the base structure, and the plurality of semiconductor structures.

14. A method of forming the integrated circuit device as claimed in any preceding claim.

15. At least one machine-accessible storage medium having instructions stored thereon, wherein the instructions, when executed on a machine, cause the machine to perform a method or realize an apparatus as claimed in any preceding claim.
